# EUROPÄISCHE PATENTSCHRIFT

(11) **EP 0 812 426 B1**
(45) Veröffentlichungstag und Bekanntmachung des Hinweises auf die Patenterteilung: **19.09.2001**
(21) Anmeldenummer: 96904746.3
(22) Anmeldetag: 28.02.1996
(51) Int. Cl.: G01R 29/18

(54) **VERFAHREN ZUR BESTIMMUNG DES DREHSINNES EINES DREHSTROMNETZES**
METHOD OF DETERMINING THE SENSE OF ROTATION OF A THREE-PHASE SYSTEM
PROCEDE PERMETTANT DE DETERMINER LE SENS DE ROTATION D'UN RESEAU TRIPHASE

(30) Priorität: 01.03.1995 DE 19508769
(43) Veröffentlichungstag der Anmeldung: 17.12.1997
(73) Patentinhaber: SIEMENS AKTIENGESELLSCHAFT, 80333 München (DE)
(72) Erfinder: REHAAG, Hans, D-13057 Berlin (DE); RÖHL, Wolfgang, D-13503 Berlin (DE)
(86) Internationale Anmeldenummer: DE9600404
(87) Internationale Veröffentlichungsnummer: WO9627137

(56) Entgegenhaltungen:
- BE-A- 768 966
- DE-A- 2 808 085
- US-A- 5 055 769

## Beschreibung

Die Erfindung betrifft eine Schaltungsanordnung zur Bestimmung des Drehsinnes der Phasen eines Drehstromnetzes, bei der ein Nulldurchgang einer der Phasen ermittelt wird,
- im Zeitpunkt der Ermittlung eines Nulldurchganges in der einen Phase die jeweilige Polarität der beiden verbleibenden Phasen ermittelt wird,
- aus dem Vergleich der Polarität der betreffenden Phasen der Drehsinn als "RECHTS" oder "LINKS" bestimmt wird und
- die Gesamtheit aller vorstehenden Schritte nach Bedarf durchgeführt wird.

Zur Bestimmung des Drehsinns ist die Benutzung elektromechanischer Drehfeldanzeiger bekannt. Diese Geräte enthalten um 120° versetzt angeordnete Magnetspulen für die Phasen des Netzes und eine drehbar angeordnete Metallscheibe. Ein Pfeilsymbol auf der Metallscheibe veranschaulicht den Drehsinn des Netzes. Ein solches Gerät ist bei der Errichtung elektrischer Anlagen zweckmäßig verwendbar, eignet sich jedoch aufgrund seiner Größe insbesondere nicht zum festen Einbau in kompakte Geräte, z. B. Niederspannungs-Leistungsschalter.

Durch die japanische Patentanmeldung JP 55-2963(A) (vgl. Patent Abstracts of Japan, March 7, 1980, Vol. 4, Nr. 27 "Phase rotation detecting circuit for three phase power supply") ist eine Schaltung mit einem Transformator bekannt geworden, der eine Eingangswicklung und zwei Ausgangswicklungen aufweist. Die Eingangswicklung ist an zwei Phasen eines Drei-Phasen-Netzes angeschlossen. An die Ausgangswicklungen sind jeweils Thyristoren angeschlossen, die ihrerseits antiparallelgeschaltet sind. Ein mit der Thyristor- Schaltung in Reihe liegendes Relais spricht bei der Einhaltung der Phasenfolge an.

Eine weitere bekannte Schaltungsanordnung (DD 254 088 B1) arbeitet unter Zuhilfenahme von drei Triggern, aus denen Impulsfolgen gewonnen werden, die mit den jeweiligen Phasenleitern phasengleich sind. Diese Impulsfolgen werden jeweils auf den Takteingang eines D-Flipflop geschaltet, wobei der D-Eingang des ersten Flipflop mit einer logischen 1 belegt ist, während die D-Eingänge des zweiten und dritten D-Flipflop mit den Q-Ausgängen des ersten und des zweiten D-Flipflop verbunden sind und die Rücksetzeingänge des ersten und zweiten D-Flipflop mit dem Takteingang des dritten D-Flipflop verbunden sind, so dass der logische Pegel am Q-Ausgang des dritten D-Flipflop als Merkmal für die Phasenfolge dient.

Nach der US-A 5 055 769 wird zum Vergleich des Drehsinnes der Netzanschlussstellen in einem größeren Gebäude eine mikroprozessorgestützte Einrichtung verwendet, die zunächst die Periodendauer einer der Phasen an einer der Anschlußstellen durch Erfassung über einen gewissen Zeitraum bestimmt. Ferner wird geprüft, ob zwei weitere Phasen vorhanden sind und ob ein Phasenunterschied besteht. Diese Schritte werden durchgeführt, um festzustellen, ob an der zu prüfenden Anschlußstelle eine gültige Konfiguration des Versorgungsnetzes besteht. Anschließend wird ein Phasennulldurchgang abgewartet, diese Phase als Referenzphase betrachtet und die Beziehung zu den verbleibenden Phasen anhand der vorgefundenen Polarität geprüft. Das Prüfgerät mit den gespeicherten Daten der vorgefundenen Netzkonfiguration wird dann zu einer zu vergleichenden Anschlußstelle des Netzes gebracht und mit dieser verbunden, um die gegebene oder fehlende Übereinstimmung festzustellen. Der Benutzer kann eine Prüfung des Drehsinns jederzeit durch Drücken einer Befehlstaste veranlassen.

Ein weiteres Verfahren zur Bestimmung des Drehsinnes in einem Drehstromnetz nach der BE 768 966 sieht die Verwendung je einer Hilfsschaltung zum Anschluß an jede der Phasen vor, wobei zwei dieser Hilfsschaltungen über zwei Ausgänge verfügen, deren Ausgangsgrößen um 90° versetzt sind. Insgesamt vier Bausteine zur logischen Verknüpfung von je zwei Signalen sind derart geschaltet, dass ein Speicherbaustein mit zwei der Ausgangsgrößen beaufschlagt ist und an seinen beiden Ausgängen das gewünschte Ergebnis in digitaler Form bereitgestellt wird. Dies geschieht in netzbezogenen periodischen Abständen.

Zur Überwachung des Drehsinnes eines Drehstromnetzes ist nach der DE 28 08 085 A1 ein Spannungskomparator vorgesehen, dem an einem ersten Eingang von zwei Phasen des Drehstromnetzes die eine Halbwelle und von der dritten Phase die andere Halbwelle invertiert zugeführt werden und dem an dem zweiten Eingang eine nichtinvertierte Halbwelle einer Phase verzögert als Referenzspannung zugeleitet wird. Der Spannungskomparator ist so eingestellt, dass er ein eine falsche Phasenfolge kennzeichnendes Fehlersignal abgibt, wenn die Referenzspannung die Spannung an seinem ersten Eingang übersteigt. Die vorgenannten Funktionen erfolgen kontinuierlich in der Weise, dass als Ausgangsgröße bei richtiger Phasenfolge ein H-Dauersignal auftritt, bei falscher Phasenfolge dagegen ein mit der Periodendauer von H zu L wechselndes (Blink-) Signal.

Der Erfindung liegt - ausgehend von der US-A 5 055 769 - die Aufgabe zugrunde, eine einfach beschaffene Schaltungsanordnung sowie ein zu ihrem Betrieb geeignetes Verfahren anzugeben, die eine von der Frequenz des zu prüfenden Netzes unabhängige Bestimmung der Phasenfolge ermöglichen und auch bei unsymmetrischer Phasenbelastung eine fehlerfreie Anzeige ergeben.

Gemäß der Erfindung wird diese Aufgabe bei einer Schaltungsanordnung der eingangs genannten Art dadurch gelöst, dass zur Bestimmung des Nulldurchganges in der einen Phase eine Komparatorschaltung dient und zur Ermittlung der Polarität der verbleibenden Phasen je eine weitere Komparatorschaltung und zur Verarbeitung der Ausgangsgrößen aller Komparatorschaltungen eine erste Logikschaltung vorgesehen ist, und dass eine weitere, durch die erste Logikschaltung gesteuerte zweite Logikschaltung Ausgangsgrößen für den Drehsinn und für die Gültigkeit der jeweils vorgenommenen Messung als logische "0"- oder "1"-Signale erzeugt, wobei ein "0"-Signal eine ungültige Messung bezeichnet.

Im Unterschied zu den eingangs erwähnten bekannten Schaltungsanordnungen bzw. Verfahren genügt es somit, gewissermaßen eine Momentaufnahme des Zustandes der Phasen des Netzes durchzuführen. Damit ist es nicht erforderlich, einen ständig arbeitenden Mikroprozessor bzw. Mikrokontroller bereitzustellen. Vielmehr kann ein bereits vorhandener und für andere Aufgaben vorgesehener Prozessor die durchzuführenden Schritte ohne Nachteil für seine Hauptaufgabe zusätzlich übernehmen.

Wie schon erwähnt, kann im Rahmen der Erfindung vorteilhaft ein bereits für andere Zwecke vorgesehener Mikroprozessor bzw. Mikrokontroller mitbenutzt werden. Hierbei kommt insbesondere der Mikroprozessor im elektronischen Auslöser eines Niederspannungs-Leistungsschalters in Betracht. Dieser hat unter Verwendung der Schaltungsanordnung gemäß der Erfindung folgende Schritte zu veranlassen:
- Abgabe eines Startbefehls zur Bestimmung eines Nulldurchganges einer ausgewählten Phase und zur gleichzeitigen Bestimmung der Polarität der beiden verbleibenden Phasen,
- Aktivierung einer Interruptserviceroutine zum Vergleich der Polaritäten der beiden verbleibenden Phasen,
- Abgabe von Steuerbefehlen zur Darbietung benutzerorientierter Symbole mittels einer Anzeigevorrichtung.

Die Erfindung wird im folgenden anhand des in den Figuren dargestellten Ausführungsbeispieles näher erläutert.

Die Figur 1 zeigt schematisch den Kurvenverlauf der Phasen eines Drehstromnetzes bei unsymmetrischer Belastung.

In der Figur 2 ist schematisch ein mit einer Anzeigevorrichtung für den Drehsinn des Netzes versehener Niederspannungs-Leistungsschalter dargestellt.

In der Figur 3 ist als Blockschaltbild eine Schaltungsanordnung zur Bestimmung des Drehsinns unter Verwendung eines Mikroprozessors gezeigt.

Die Figur 4 zeigt ein weiteres Beispiel für die Bestimmung des Drehsinns mit einer eigenständigen Schaltungsanordnung.

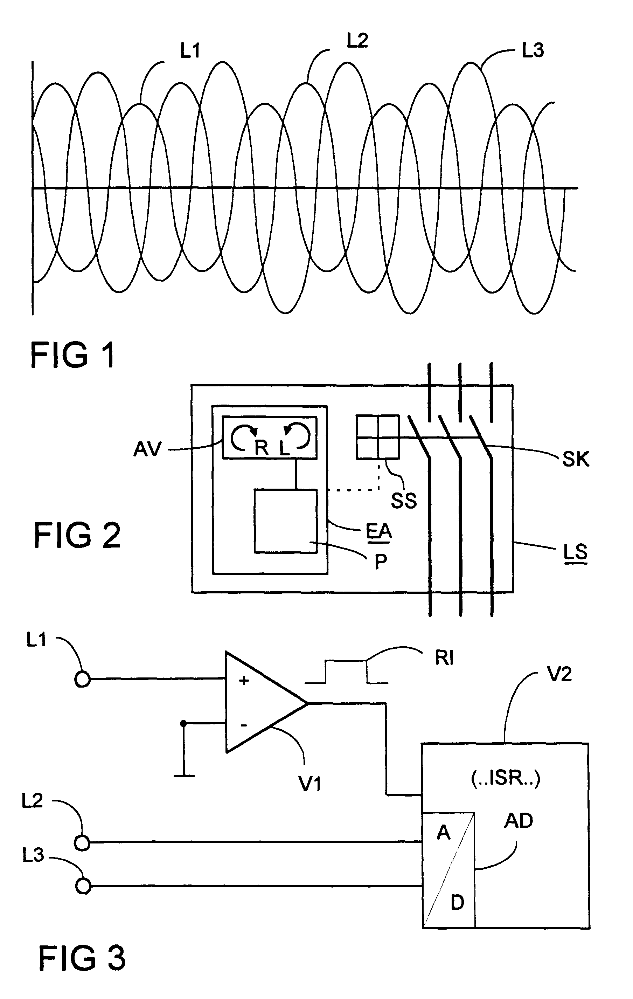

Die in der Figur 1 gezeigten Phasen L1, L2 und L3 eines Drehstromnetzes können eine beliebige Frequenz im technischen Bereich, d. h. zwischen etwa 16 2/3 Hz und 400 Hz aufweisen. Die gezeigten unterschiedlichen Amplituden beruhen auf unsymmetrischer Belastung des Netzes. Daher kann in wechselnder Folge jede der Phasen L1, L2 und L3 betroffen sein.

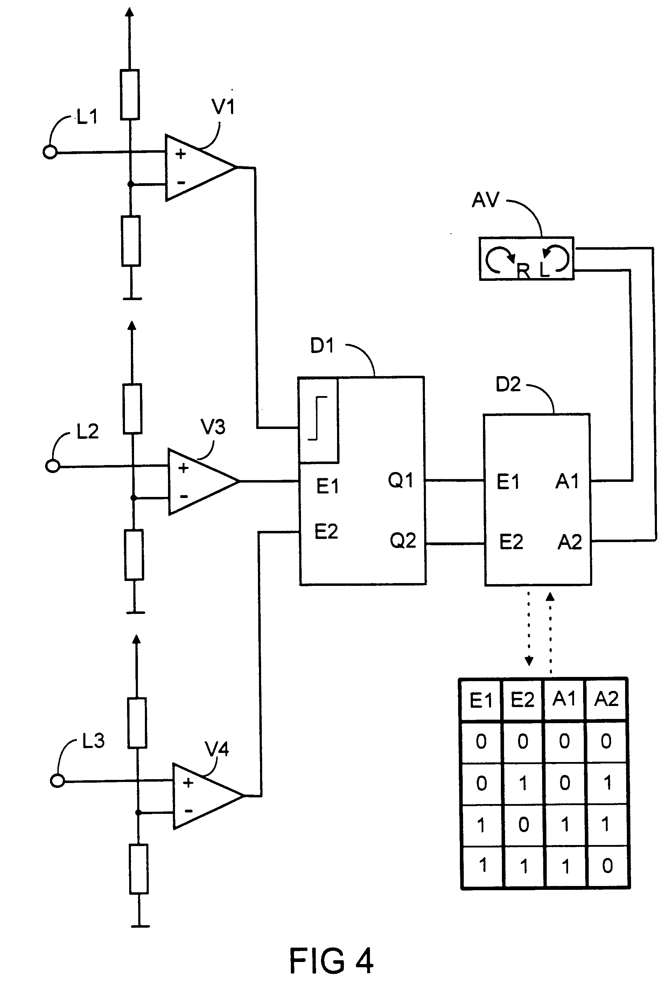

Der in der Figur 2 schematisch gezeigte Niederspannungs-Leistungsschalter LS umfaßt in bekannter Weise Schaltkontakte SK, die durch ein Schaltschloß SS steuerbar sind. Ein elektronischer Auslöser EA enthält einen Mikroprozessor P sowie eine Anzeigevorrichtung AV. Auf dieser kann neben anderen für den Benutzer wesentlichen Größen auch der Drehsinn des Netzes als Zeichen oder Symbol dargestellt werden. Beispiele für die Betätigung der Anzeigevorrichtung AV werden nun anhand der Figuren 3 und 4 erläutert.

Die nachfolgend anhand der Figuren 3 und 4 zu erläuternden Schaltungsanordnungen werden weder durch die Frequenz, noch durch eine Unsymmetrie der in Figur 1 gezeigten Art beeinflußt.

Gemäß der Figur 3 wird dem positiven Eingang einer Komparatorschaltung V1 ein von der Phase L1 abgeleitetes Signal zugeführt, während an dem negativen Eingang ein Bezugspotential angelegt ist. Am Ausgang der Komparatorschaltung V1 erscheint somit jeweils im Nulldurchgang der Phase L1 ein schematisch gezeigter Rechteckimpuls RI.

Ein Mikroprozessor V2 verarbeitet den in der Figur 3 gezeigten Rechteckimpuls RI zugleich mit analogen Signalen, die von den Phasen L2 und L3 abgeleitet sind und einem zu dem Mikroprozessor V2 gehörenden A/D-Wandler AD zugeführt werden. Durch den Rechteckimpuls RI wird eine in dem Mikroprozessor V2 hinterlegte Interruptserviceroutine ISR aktiviert. Dies kann in geeigneten Abständen geschehen, z. B. einmal pro Sekunde. Die ISR hat folgenden Aufbau: 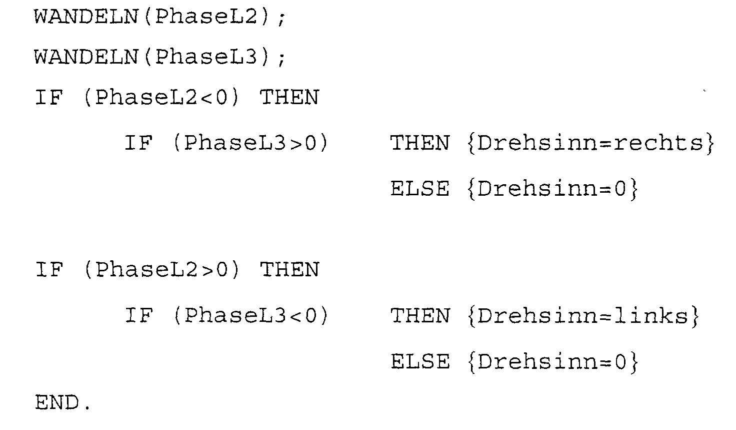 In der ISR ist als mögliches Ergebnis auch der Wert "0" für den Drehsinn vorgesehen. Dies stellt ein ungültiges Ergebnis dar, das insbesondere durch den Ausfall einer Phase oder durch eine ungewöhnlich große Phasenverschiebung verursacht sein kann.

Die in der Figur 3 gezeigte Schaltungsanordnung eignet sich besonders für den Fall, dass der Mikroprozessor V2 in einer elektrischen Anlage oder einem Schaltgerät bereits vorhanden ist. Durch die im Rahmen der Ermittlung des Drehsinnes nur kurzdauernde und in Abständen durchzuführende Interruptserviceroutine ISR wird die Rechenleistung des Mikroprozessors nur geringfügig in Anspruch genommen. Daher kann die gezeigte Schaltung vorteilhaft in Niederspannungs-Leistungsschaltern eingesetzt werden, deren elektronische Auslöser einen für den Schutz gegen Überströme eingesetzten Mikroprozessor enthalten.

Für die Ermittlung des Drehsinnes eignet sich auch die in der Figur 4 gezeigte Schaltungsanordnung. In dieser wird von jeder der Phasen L1, L2 und L3 ein Signal abgeleitet und dem positiven Eingang einer der betreffenden Phase zugeordneten Komparatorschaltung V1, V3 bzw. V4 zugeführt. Eine erste Logikschaltung D1 wird durch das Nulldurchgangs-Signal der Phase L1 (Komparatorschaltung V1) getriggert und vergleicht die Polarität der von den Komparatorschaltungen V3 und V4 gelieferten Signale der Phasen L2 und L3 an den Eingängen E1 und E2. Die Ausgangsgrößen Q1 und Q2 der Logikschaltung D1 werden in einer zweiten Logikschaltung D2 gemäß der zu der Figur 4 gehörenden Wahrheitstabelle verarbeitet. Dazu gibt der Ausgang A1 den Drehsinn in der Form 0=RECHTS und 1=LINKS wieder. Am Ausgang A2 wird ausgegeben, ob ein gültiger Drehsinn ermittelt werden konnte. Ist A2=0, so liegt einer der vorstehend bereits erläuterten Gründe vor, die einer Ermittlung des Drehsinnes entgegenstehen.

## Patentansprüche

1. Schaltungsanordnung zur Bestimmung des Drehsinns der Phasen (L1, L2, L3) eines Drehstromnetzes, bei der
- ein Nulldurchgang einer der Phasen (L1) ermittelt wird,
- im Zeitpunkt der Ermittlung eines Nulldurchganges in der einen Phase (L1) die jeweilige Polarität der beiden verbleibenden Phasen (L2, L3) ermittelt wird,
- aus dem Vergleich der Polaritäten der betreffenden Phasen (L2, L3) der Drehsinn als "RECHTS" oder "LINKS" bestimmt wird und
- die Gesamtheit aller vorstehenden Schritte nach Bedarf durchgeführt wird,
**dadurch gekennzeichnet, dass** zur Bestimmung des Nulldurchganges in der einen Phase (L1) eine Komparatorschaltung (V1) dient und zur Ermittlung der Polarität der verbleibenden Phasen (L2, L3) je eine weitere Komparatorschaltung (V3, V4) und zur Verarbeitung der Ausgangsgrößen aller Komparatorschaltungen (V1, V3, V4) eine erste Logikschaltung (D1) vorgesehen ist, und dass eine weitere, durch die erste Logikschaltung (D1) gesteuerte zweite Logikschaltung (D2) Ausgangsgrößen für den Drehsinn und für die Gültigkeit der jeweils vorgenommenen Messung als logische "0" oder "1"-Signale erzeugt, wobei ein "0"-Signal eine ungültige Messung bezeichnet.

2. Verfahren zum Betrieb einer Schaltungsanordnung nach Anspruch 1,
**dadurch gekennzeichnet, dass** durch einen Mikroprozessor (P) in dem elektronischen Auslöser eines Niederspannungs-Leistungsschalters (LS) folgende Schritte durchgeführt werden:
- Abgabe eines Startbefehls zur Bestimmung eines Nulldurchganges einer ausgewählten Phase (L1) und zur gleichzeitigen Bestimmung der Polarität der beiden verbleibenden Phasen (L2, L3),
- Aktivierung einer Interruptserviceroutine (ISR) zum Vergleich der Polaritäten der beiden verbleibenden Phasen (L2, L3),
- Abgabe von Steuerbefehlen zur Darbietung benutzerorientierter Symbole mittels einer Anzeigevorrichtung (AV).

## Claims

1. Circuit arrangement for determining the sense of rotation of the phases (L1, L2, L3) of a three-phase system, in which
- a zero crossing of one of the phases (L1) is determined,
- at the instant of the determination of a zero crossing in the one phase (L1), the respective polarity of the two remaining phases (L2, L3) is determined,
- the sense of rotation is determined as "RIGHT" or "LEFT" from the comparison of the polarities of the relevant phases (L2, L3), and
- all of the above steps are carried out in their entirety as required, **characterized in that** a comparator circuit (V1) is used for the purpose of determining the zero crossing in the one phase (L1) and one further comparator circuit (V3, V4) each is provided for the purpose of determining the polarity of the remaining phases (L2, L3) and a first logic circuit (D1) is provided for the purpose of processing the output variables of all the comparator circuits (V1, V3, V4), and in that a further, second logic circuit (D2) controlled by the first logic circuit (D1) generates output variables for the sense of rotation and for the validity of the respectively undertaken measurement as logic "0" or "1" signals, a "0" signal denoting an invalid measurement.

2. Method for operating a circuit arrangement according to Claim 1, **characterized in that** the following steps are carried out by a microprocessor (P) in the electronic tripping device of a low-voltage circuit-breaker (LS) :
- outputting a starting command for the purpose of determining a zero crossing of a selected phase (L1) and of simultaneously determining the polarity of the two remaining phases (L2, L3),
- activating an interrupt service routine (ISR) for the purpose of comparing the polarities of the two remaining phases (L2, L3), and
- outputting control commands for the purpose of presenting user-orientated symbols by means of a display device (AV).

## Revendications

1. Montage pour la détermination du sens de rotation des phases (L1, L2, L3) d'un réseau triphasé, dans lequel
- un passage à zéro de l'une des phases (L1) est déterminé,
- à l'instant de la détermination d'un passage à zéro dans l'une (L1) des phases, la polarité associée des deux phases (L2, L3) restantes est déterminée,
- le sens de rotation est déterminé comme "à droite" ou "à gauche" à partir de la comparaison des polarités des phases (L2, L3) concernées, et
- la totalité de toutes les étapes précédentes est effectuée au besoin,
**caractérisé en ce qu'**un circuit (V1) comparateur sert à la détermination du passage à zéro de l'une (L1) des phases et chaque fois un circuit (V3, V4) comparateur supplémentaire sert à la détermination de la polarité des phases (L2, L3) restantes et un premier circuit (D1) logique sert au traitement des grandeurs de sortie de tous les circuits (V1, V3, V4) comparateurs et en ce qu'un deuxième circuit (D2) logique supplémentaire, commandé par le premier circuit (D1) logique, produit des grandeurs de sortie pour le sens de rotation et pour la validité de la mesure effectuée sous la forme de signaux "0" ou "1" logiques, un signal "0" désignant une mesure non valable.

2. Procédé pour faire fonctionner un montage suivant la revendication 1,
**caractérisé en ce que** les étapes suivantes sont effectuées par un micro-processeur (P) dans le déclencheur électronique d'un disjoncteur (LS) basse tension :
- fourniture d'une instruction de départ pour déterminer un passage à zéro d'une phase (L1) sélectionnée et pour déterminer en même temps la polarité des deux phases (L2, L3) restantes,
- activation d'une routine (ISR) de traitement d'interruption pour la comparaison des polarités des deux phases (L2, L3) restantes,
- fourniture d'instructions de commande pour présenter des symboles destinées à l'utilisateur au moyen d'un dispositif (AV) d'affichage).
